# EUROPÄISCHE PATENTANMELDUNG

(11) **EP 0 942 468 A2**
(43) Veröffentlichungstag der Anmeldung: **15.09.1999**
(21) Anmeldenummer: 99104708.5
(22) Anmeldetag: 10.03.1999
(51) Int. Cl.: H01L 23/467, H01L 23/367

(54) **Modulgrundplatte zur Kühlung elektrischer Bauelemente**

(30) Priorität: 13.03.1998 DE 19810919
(71) Anmelder: ABB Daimler-Benz Transportation (Technology) GmbH, 13627 Berlin (DE)
(72) Erfinder: Baumann, Heinrich Dr.-Ing., 76676 Graben-Neudorf (DE)
(74) Vertreter: Luderschmidt, Schüler & Partner GbR

(57) **Zusammenfassung**

Es wird eine Modulgrundplatte zur Kühlung elektrischer Bauelemente unter Einsatz eines gewellten, von einem Kühlmedium umströmten Bandes vorgeschlagen. Das gewellte Band (1) ist an seinen zur Verlötung mit einer die wärmeproduzierenden elektrischen Bauelemente tragenden Grundplatte (7) bestimmten Wellentälern (3) mit Aussparungen (2) versehen. Zweckmäßig sind auf den Wellenbergen (4) befindliche Schlitze (9 jeweils zwischen den auf den Wellentälern (3) befindlichen Aussparungen (2) sowohl in Längsrichtung als auch in Querrichtung jeweils um eine halbe Teilung versetzt vorgesehen. Durch die Schlitze (5) werden Wellenbergabschnitte gebildet, deren Scheitel abwechselnd gegeneinander versetzt rechts und links der gedachten Wellenachse angeordnet sind.

## Beschreibung

Die Erfindung bezieht sich auf eine Modulgrundplatte zur Kühlung elektrischer Bauelemente gemäß dem Oberbegriff des Anspruchs 1. Die Erfindung kann bei der Kühlung von Halbleitermodulen, beispielsweise IGBT-Modulen von Stromrichtern, verwendet werden.

Aus der DE 41 31 739 C2 ist eine Kühleinrichtung für elektrische Bauelemente mit zumindest einem flüssigkeitsdurchströmten flachen Hohlraum sowie Zulauf- und Ablaufanschlüssen bekannt. Der Hohlraum ist zwischen zwei im wesentlichen plattenförmigen Bauteilen gebildet. Im Hohlraum ist eine etwa die Form eines gewellten Bandes aufweisende Einlage angeordnet, wobei die Einlage quer zur Durchströmungsrichtung eine Vielzahl von Wellen aufweist, die sich in Durchströmungsrichtung lediglich über eine Teilstrecke der Länge des Hohlraumes erstrecken und mehrere Reihen solcher Wellen unmittelbar aufeinanderfolgend und hintereinanderliegend angeordnet sind. Die jeweils nachfolgende Reihe ist gegenüber der vorhergehenden Reihe seitlich versetzt angeordnet. Die Teilstrecken betragen etwa 2 bis 5 mm.

Der Erfindung liegt die Aufgabe zugrunde, eine Modulgrundplatte zur Kühlung elektrischer Bauelemente der eingangs genannten Art anzugeben, die ein gutes Wärmeübertragungsverhalten aufweist und auch bei Auftreten relativ großer Temperaturdifferenzen eine lange Lebensdauer gewährleistet.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß die vorgeschlagene Modulgrundplatte einfach und preisgünstig herstellbar ist. Die zur Wärmeübertragung an das Kühlmedium herangezogene Oberfläche ist relativ groß, was die Schaffung einer kompakten, leistungsstarken Baueinheit mit stark erhöhtem Wärmeübertragungskoeffizienten begünstigt. Die in den Wellentälern eingebrachten Aussparungen reduzieren die bei Temperaturänderungen in der Lötschicht auftretenden Spannungen erheblich, was eine lange Lebensdauer gewährleistet.

Die Erfindung wird nachstehend anhand der in der Zeichnung dargestellten Ausführungsbeispiele erläutert. Es zeigen:
- Fig. 1: eine perspektivische Ansicht eines gewellten Bandes,
- Fig. 2: eine perspektivische Ansicht einer Modulgrundplatte,
- Fig. 3: eine Sicht auf ein zusätzlich bearbeitetes gewelltes Band,
- Fig. 4: eine Sicht auf ein Band.

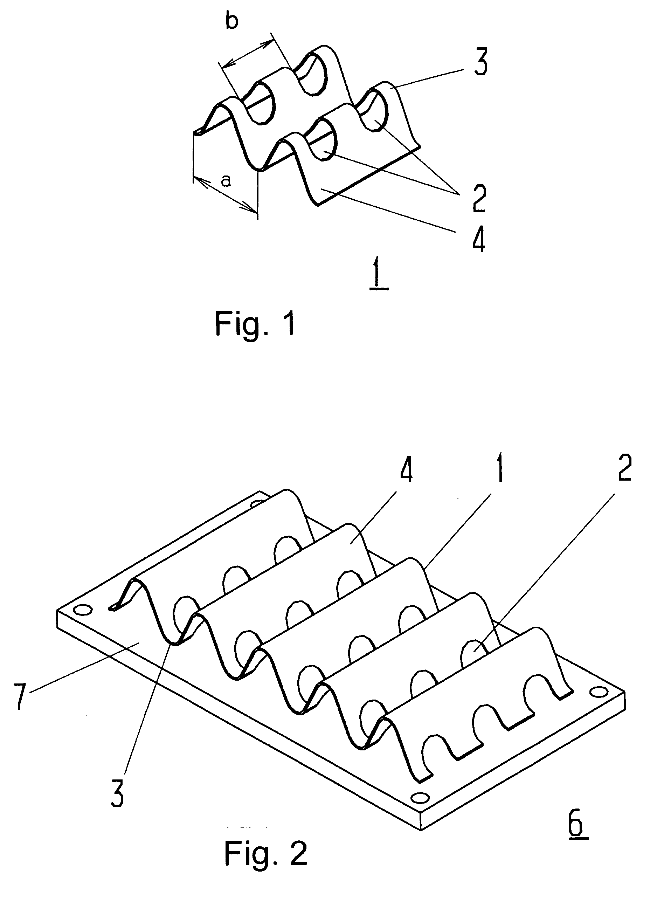

In Fig. 1 ist eine perspektivische Ansicht eines gewellten Bandes dargestellt. Es ist ein gewelltes Band 1 mit Wellentälern 3 und Wellenbergen 4 zu erkennen. Der Abstand zwischen zwei Wellenbergen 4 bzw. zwischen zwei Wellentälern 3 ist mit a bezeichnet. Die Wellentäler 3 sind in regelmäßigen Abständen mit Aussparungen 2 versehen (zur besseren Darstellung der Aussparungen 2 ist das gewellte Band 1 um 180° gewendet, so daß die Wellentäler oben liegen). Der Abstand zwischen zwei Aussparungen ist mit b bezeichnet und liegt vorzugsweise im Bereich von 5 bis 15 mm.

In Fig. 2 ist eine perspektivische Ansicht einer Modulgrundplatte dargestellt. Eine Modulgrundplatte 6 besteht aus einer ebenen Grundplatte 7 mit mindestens einem auf der ersten Hauptoberfläche aufgelöteten gewellten Band 1. Die Grundplatte 7 ist vorzugsweise aus AlSiC (Aluminium-infiltriertes Siliziumkarbid) gebildet und vernickelt, um ein einfaches Verlöten zu ermöglichen. Der Temperaturausdehnungskoeffizient von AlSiC weicht von demjenigen von Silizium und der Substratkeramik nur gering ab, so daß Festigkeitsprobleme aufgrund stark unterschiedlicher Temperaturausdehnungskoeffizienten vermieden werden und eine Langzeitstabilität sichergestellt ist.

Wie leicht zu erkennen ist, ergibt sich aufgrund der Aussparungen 2 in Richtung der Wellenachse eine punktweise Lötverbindung der Wellentäler 3 mit der Grundplatte 7, was die Steifigkeit der Lötverbindung erheblich reduziert und die bei Temperaturänderungen auftretenden Spannungen in den unkritischen Bereich herabsetzt. Das gewellte Band ist in Richtung senkrecht zur Wellenachse relativ biegeweich, daher treten nach dem Verlöten von Grundplatte 7 und Band 1 keine hohen Spannungen in dieser Richtung auf.

Zur Bildung eines von einem Kühlmedium durchströmbaren Hohlraumes sind die Wellenberge 4 mit einer nicht dargestellten Deckplatte sowie Seitenplatten abgedeckt, jedoch nicht mit diesen Platten verbunden. Die Hauptströmrichtung des Kühlmediums liegt parallel zur Wellenrichtung. Das gewellte Band 1 verbessert wegen der stark vergrößerten Oberfläche im Vergleich zur Oberfläche der Grundplatte den Wärmeübergang zum Kühlmedium. Die Oberfläche der Grundplatte muß nicht mit speziellen, nur unter Einsatz aufwendiger und teurer Verfahrensschritte realisierbaren Kühlstrukturen zur Verbesserung des Wärmeübertragungsverhaltens versehen werden. Auf der zweiten Hauptoberfläche der Grundplatte 7 sind die wärmeproduzierenden Halbleiter (Silziumchips) appliziert. Als Kühlmedium kann beispielsweise Brauchwasser verwendet werden.

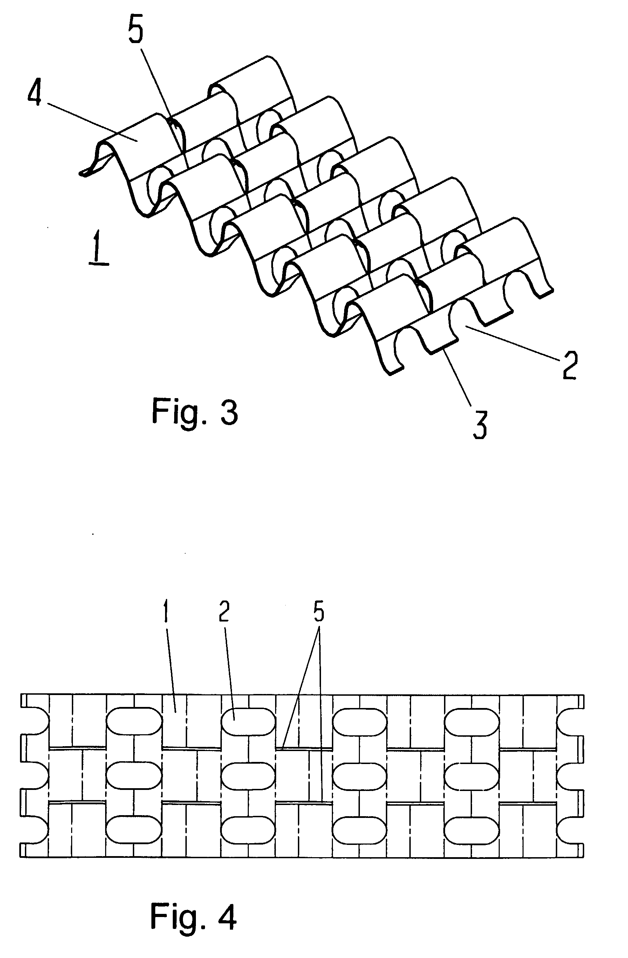

In Fig. 3 ist eine Sicht auf ein zusätzlich bearbeitetes gewelltes Band dargestellt. Dieses gewellte Band 1 weist außer den Aussparungen 2 in den Wellentälern 3 zusätzliche Schlitze 5 in den Wellenbergen 4 auf. Der Abstand zwischen zwei Schlitzen 5 kann wiederum b betragen oder einem Vielfachen von b entsprechen. Durch die Schlitze 5 werden Wellenbergabschnitte gebildet, deren Scheitel abwechselnd gegeneinander versetzt rechts und links von der gedachten Wellenachse angeordnet sind. Das Abbiegen der Wellenbergabschnitte kann unter Zuhilfenahme eines geeigneten Werkzeuges vor oder nach dem Verlöten des Bandes 1 mit der Grundplatte 7 erfolgen.

Die Ausführungsvariante des gewellten Bandes gemäß Fig. 3 stellt wegen der kurzen überströmten Längen und intensiver Verwirbelung des Kühlmediums der regelmäßig unterbrochenen, längs der Wellenachse verlaufenden Bandbereiche einen verbesserten Wärmeübergang sicher.

In Fig. 4 ist eine Sicht auf ein Band dargestellt, um zu zeigen, welche Ausstanzungen zweckmäßig bereits vor dem Biegen im Band 1 einzubringen sind. Wie gut zu erkennen ist, liegen die den Wellenbergen zuzuordnenden Schlitze 5 jeweils zwischen den den Wellentälern zuzuordnenden Aussparungen 2, sowohl in Längsrichtung als auch in Querrichtung jeweils um die halbe Teilung versetzt.

## Patentansprüche

1. Modulgrundplatte zur Kühlung elektrischer Bauelemente unter Einsatz eines gewellten, von einem Kühlmedium umströmten Bandes, dadurch gekennzeichnet, daß das gewellte Band (1) an seinen zur Verlötung mit einer die wärmeproduzierenden elektrischen Bauelemente tragenden Grundplatte (7) bestimmten Wellentälern (3) mit Aussparungen (2) versehen ist.

2. Modulgrundplatte nach Anspruch 1, dadurch gekennzeichnet, daß der Abstand (b) zwischen zwei Aussparungen (2) in Richtung der Wellenachse 5 bis 15 mm beträgt.

3. Modulgrundplatte nach Anspruch 1 und/oder 2, dadurch gekennzeichnet, daß auf den Wellenbergen (4) befindliche Schlitze (5) jeweils zwischen den auf den Wellentälern (3) befindlichen Aussparungen (2) sowohl in Längsrichtung als auch in Querrichtung jeweils um eine halbe Teilung versetzt vorgesehen sind.

4. Modulgrundplatte nach Anspruch 3, dadurch gekennzeichnet, daß durch die Schlitze (5) Wellenbergabschnitte gebildet werden, deren Scheitel abwechselnd gegeneinander versetzt rechts und links der gedachten Wellenachse angeordnet sind.

5. Modulgrundplatte nach einem der Ansprüche 1 bis 4, dadurch gekennzeichnet, daß die Grundplatte (7) aus AlSiC gebildet ist.
